# FASCICULE DE BREVET EUROPEEN

(11) **EP 1 083 432 B1**
(45) Date de publication et mention de la délivrance du brevet: **03.03.2004**
(21) Numéro de dépôt: 00402317.2
(22) Date de dépôt: 18.08.2000
(51) Int. Cl.: G01R 15/18

(54) **Capteur inductif pour la mesure d'un courant dans un conducteur**
Induktiver Stromsensor zur Messung des Stroms in einem Leiter
Inductive sensor for measuring the current in a conductor

(30) Priorité: 09.09.1999 FR 9911306
(43) Date de publication de la demande: 14.03.2001
(73) Titulaire: PIOCH S.A., 06515 Carros Cédex 1 (FR)
(72) Inventeur: Pioch, Olivier, 06200 Nice (FR); Smirani, Imad, 06160 Juan Les Pins (FR)
(74) Mandataire: Blot, Philippe Robert Emile

(56) Documents cités:
- EP-A- 0 652 441
- EP-A- 0 838 686
- EP-A- 0 866 338
- FR-A- 2 559 268

## Description

La présente invention concerne un capteur inductif pour la mesure d'un courant dans un conducteur, du type comportant un bobinage ayant la forme générale d'un anneau délimitant un passage pour ledit conducteur, lequel bobinage s'étend de manière homogène sur l'essentiel de la circonférence de l'anneau à l'exception d'un tronçon où le bobinage présente une discontinuité structurelle.

Pour mesurer le courant circulant dans un conducteur, il est connu de disposer autour de celui-ci une bobine à spires jointives refermée sur elle-même, constituant un anneau bobiné. Une telle bobine est connue sous le nom de bobine de Rogowski.

Lors du passage d'un courant alternatif à l'intérieur du conducteur, une tension est induite aux bornes de la bobine. Cette tension est proportionnelle à la dérivée par rapport au temps de l'intensité du courant circulant dans le conducteur. Pour évaluer ce courant, les bornes de la bobine sont reliées à un circuit intégrateur connu en soi.

Un tel capteur est couramment utilisé sur des barres d'entrée et/ou de sortie d'un transformateur triphasé.

Dans les installations connues, un capteur est disposé sur chacune des quatre barres assurant l'alimentation triphasée. Chaque capteur comporte un unique bobinage porté par un support amagnétique de section constante replié sur lui-même pour former un anneau. Le bobinage comporte des spires régulièrement réparties autour du support amagnétique. Le support amagnétique présente une discontinuité fomée par une interruption délimitée entre ses extrémités repliées l'une vers l'autre.

De même, le bobinage présente dans cette région du support annulaire amagnétique une discontinuité structurelle, le nombre de spires y étant réduit. Généralement, la région d'interruption du support amagnétique est même dépourvue de spires. Cette région correspond aux extrémités du bobinage, d'où partent des fils constituant les bornes du bobinage.

Dans la région d'installation des capteurs, les barres d'alimentation triphasées sont généralement disposées côte à côte en étant alignées. Ainsi, chacun des capteurs est influencé par le courant circulant dans les barres voisines. En particulier, du fait de la présence d'une discontinuité dans la structure toroïdale du bobinage, suivant la position du capteur autour d'une barre et, notamment sa position par rapport aux barres voisines, la tension obtenue à ses bornes peut varier de manière significative, du fait de l'influence des phases voisines circulant dans les barres adjacentes.

Ainsi, de manière générale, la dissymétrie de la structure de la bobine confère une forte sensibilité du capteur au champ magnétique extérieur, cette sensibilité dépendant notamment de la position du capteur.

EP-A-0.652.441 décrit une bobine formant un capteur selon le préambule de la rev. 1-FR-A-2.559.268 décrit un autre capteur en forme de bobine.

L'invention a pour but de proposer un capteur inductif peu sensible au champ magnétique perturbateur provenant notamment de barres conductrices de courant disposées dans le voisinage immédiat.

A cet effet, l'invention a pour objet un capteur inductif selon la revendication 1.

Suivant des modes particuliers de réalisation, l'invention comporte l'une ou plusieurs des caractéristiques des revendications dépendantes.

L'invention sera mieux comprise à la lecture de la description qui va suivre donnée uniquement à titre d'exemple et faite en se référant aux dessins sur lesquels :
- la figure 1 est une vue en perspective éclatée d'un capteur inductif selon l'invention ;
- la figure 2 est une vue en élévation d'un bobinage avant mise en forme entrant dans la composition d'un bobinage torique du capteur selon l'invention ;
- les figures 3 et 4 sont des courbes de la réponse d'un capteur de l'état de la technique et d'un capteur selon l'invention en présence et en l'absence de champs perturbateurs.

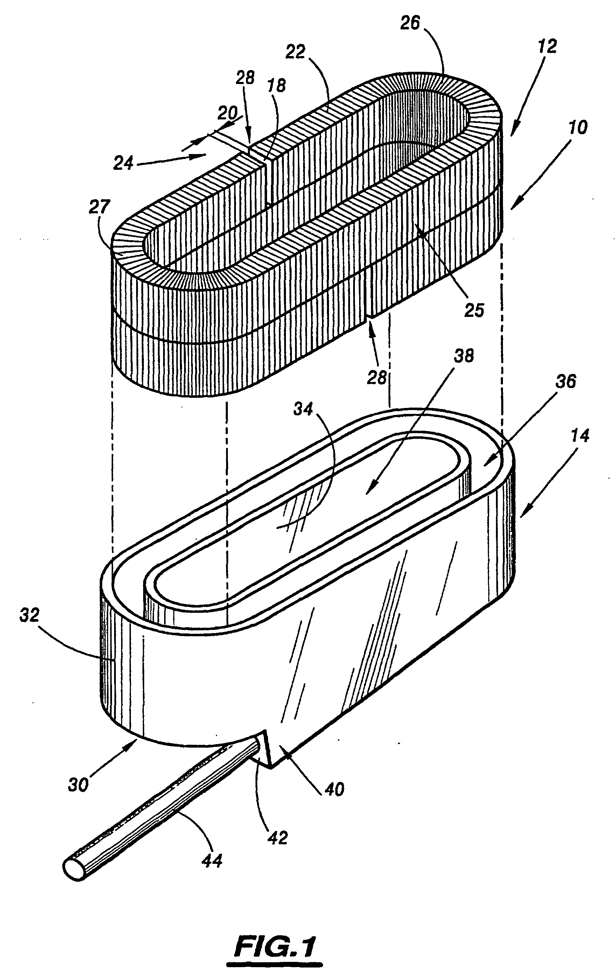

Le capteur selon l'invention, représenté sur la figure 1, comporte essentiellement deux bobines identiques 10, 12 assemblées coaxialement tête-bêche à l'intérieur d'un boîtier de protection et de maintien 14. Chaque bobine comporte un support amagnétique ou noyau 18 formé d'une barre repliée sur elle-même pour délimiter un anneau. Les extrémités en regard du noyau sont séparées par un intervalle 20 de taille réduite par rapport à celle de la bobine.

Dans l'ensemble de la description, le terme anneau désigne le volume engendré par le déplacement d'un contour fermé autour d'un axe, le déplacement du contour fermé s'effectuant suivant toute courbe génératrice. Un tel volume est parfois appelé abusivement tore.

Sur l'essentiel de la longueur du noyau 18 de chaque bobine est enroulé un ensemble de spires jointives constituant un bobinage 22. Les spires sont régulièrement espacées suivant la longueur du noyau. Chaque bobinage comporte par exemple 1065 spires. Le fil utilisé pour le bobinage a un diamètre de 0,25 mm.

Chaque bobinage comporte avantageusement deux couches de spires bobinées en sens inverse réparties sur deux épaisseurs superposées. Les deux couches de spires ont le même nombre de spires. Aussi, les extrémités du bobinage, qui sont prolongées par des brins conducteurs, émergent du bobinage à une même extrémité du noyau.

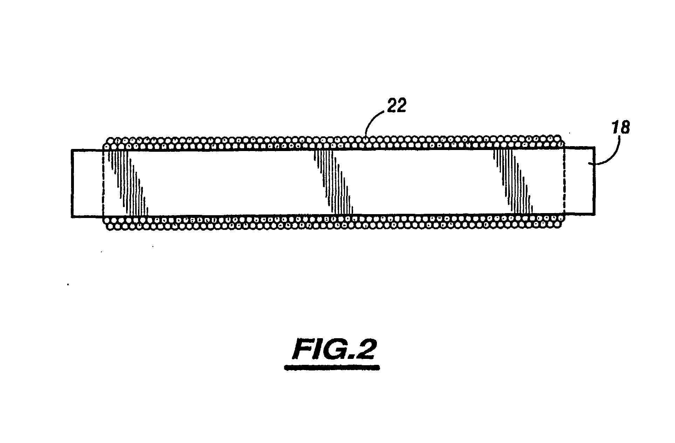

Sur la figure 2 est représenté le bobinage 22 disposé sur le noyau 18, avant mise en forme de la bobine. En effet, afin de réduire le coût de fabrication de chacune des bobines, celles-ci sont réalisées à partir d'une barre rectiligne réalisée en un matériau amagnétique et destinée à former le noyau 18. Autour de cette barre sont bobinées les deux couches de spires. La bobine ainsi formée subit ensuite une opération de formage par déformation plastique du noyau 18. Cette déformation plastique consiste à rabattre les deux extrémités libres du noyau l'une vers l'autre, donnant ainsi à la bobine une forme annulaire, comme représenté sur la figure 1.

Dans l'exemple considéré, l'anneau présente deux faces principales rectilignes et parallèles 24, 25 reliées l'une à l'autre par des tronçons semi-cylindriques 26, 27. Les extrémités du noyau 18 sont disposées en vis-à-vis sensiblement au milieu de la face 24 et délimitent l'intervalle 20.

On conçoit qu'après mise en forme, le bobinage 22 de chaque bobine présente une discontinuité structurelle 28 dans la région de l'interruption 20. En particulier, cette région est essentiellement dépourvue de spires.

Selon l'invention, le capteur comporte deux bobines identiques disposées coaxialement l'une au-dessus de l'autre de sorte que les discontinuités structurelles 28 des bobinages soient disposées symétriquement par rapport à l'axe commun des bobines, comme représenté sur la figure 1. Les bobines ainsi disposées sont reliées en série et mises en place dans un logement annulaire du boîtier 14. Les fils reliant en série les deux bobines sont agencés comme représenté sur la figure 1.

Les fils de liaison des deux bobines sont disposés le long des bobines sur leur périphérie extérieure dans le plan de jonction des deux bobines posées l'une sur l'autre.

Le boîtier 14 est réalisé en matière plastique par moulage. Il comporte un fond 30 de forme oblongue bordé extérieurement par une jupe 32 s'étendant perpendiculairement au fond. A l'intérieur, est prévue une jupe interne 34 s'étendant parallèlement à la jupe externe 32. Elles délimitent entre elles un logement annulaire 36 de réception des bobines 10 et 12. La hauteur des jupes 30, 34 est sensiblement égale au double de la hauteur d'une bobine 10, 12.

La jupe interne 34 délimite en outre intérieurement un conduit oblong 38 pour le passage d'une tige conductrice. De manière générale, le conduit a une forme correspondante à la section de la tige utilisée.

Le fond 30 présente une saillie 40 formant une rampe s'étendant suivant la longueur du boîtier. Celle-ci s'achève par un épaulement 42 d'où débouche perpendiculairement une gaine 44 pour le passage des deux fils de liaison des bobines 10, 12 montées en série.

Pour l'assemblage du capteur, les deux bobines 10, 12 sont disposées à l'intérieur du logement annulaire 36. Une résine d'encapsulage telle qu'une résine polyuréthane est coulée dans le boîtier autour des bobines. Ainsi, les bobinages 22 des bobines sont noyées dans la résine d'encapsulage, ce qui assure une protection des bobines vis-à-vis des contraintes mécaniques et thermiques et renforce les connexions des fils conducteurs.

La présence dans le capteur de deux bobines dont les discontinuités structurelles des bobinages sont réparties de part et d'autre de l'axe des bobines permet de diminuer l'influence de ces discontinuités structurelles sur le signal mesuré, en présence de champs extérieurs perturbateurs.

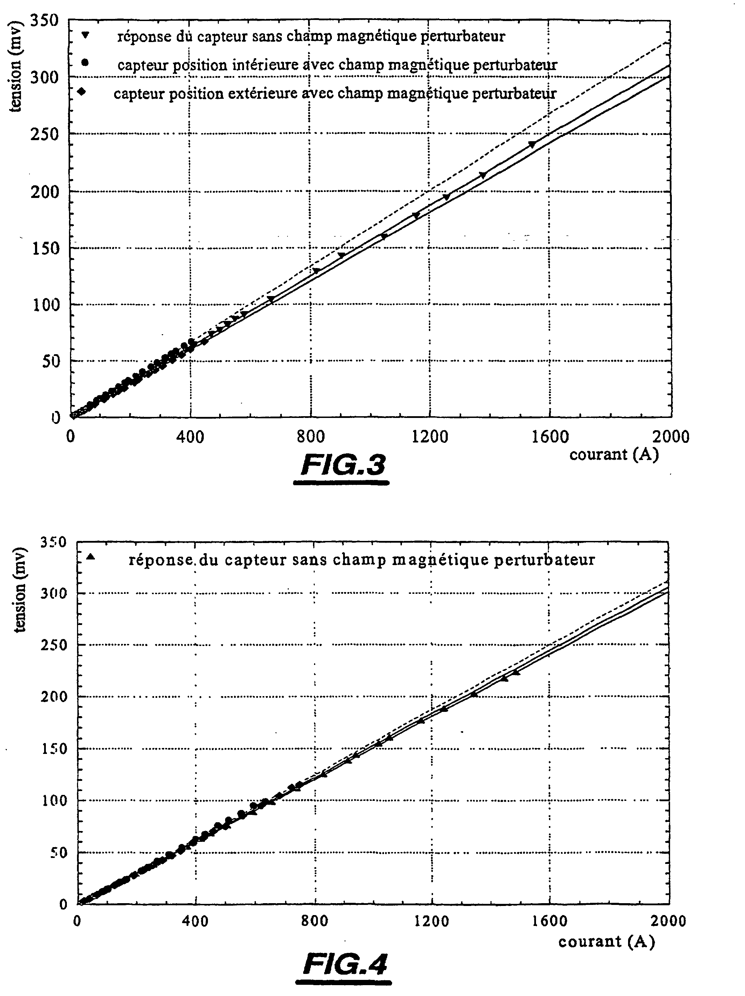

Sur la figure 3 est représenté la réponse d'un capteur de l'état de la technique en fonction de sa position par rapport à un champ magnétique perturbateur. Ce capteur présente une forme annulaire et est constitué d'une unique bobine telle que représentée sur la figure 1. Ainsi, ce capteur est identique au capteur selon l'invention mais comporte une bobine et non deux.

Les mesures ont été effectuées en l'absence d'un champ perturbateur et en présence d'un champ perturbateur, ceci pour. deux positions distinctes du capteur.

En l'absence de champ, les mesures sont représentées par des triangles.

En présence du champ, dans une première position, la discontinuité structurelle du capteur est orientée vers le conducteur induisant le champ magnétique perturbateur. Les résultats des mesures sont représentés par des ronds. Dans l'autre position, dans laquelle la discontinuité structurelle est disposée à l'opposé du conducteur à l'origine du champ magnétique perturbateur, les résultats des mesures sont représentés par des carrés.

On constate sur la figure 3 que les réponses du capteur pour les différentes intensités où des mesures ont été réalisées sont portées par des droites, dont le coefficient directeur correspond à la sensibilité du capteur. Lorsque les intensités augmentent, les droites ont tendance à diverger les unes des autres d'un écart substantiel dû à la présence du champ perturbateur.

Sur la figure 4, est représentée la réponse d'un capteur tel que représenté sur la figure 1, dans les mêmes conditions expérimentales. Les mêmes symboles sont utilisés .On constate sur cette figure que les droites représentatives de la sensibilité du capteur, en l'absence et en présence de champ magnétique, sont très proches l'une de l'autre, ce qui montre une réduction de la sensibilité du capteur aux perturbations électromagnétiques ambiantes.

Dans le mode de réalisation envisagé sur la figure 1, le capteur comporte deux bobines reliées en série. Toutefois, en variante, le capteur comporte plus de deux bobines, et notamment quatre bobines disposées coaxialement, chaque bobine présentant une discontinuité structurelle. Les discontinuités structurelles sont alors angulairement réparties régulièrement autour de l'axe des bobinages. Ainsi, les écarts angulaires mesurés depuis l'axe des bobinages coaxiaux séparant les discontinuités structurelles sont égaux.

## Revendications

1. Capteur inductif pour la mesure d'un courant dans un conducteur, comportant un bobinage (10) ayant la forme générale d'un anneau délimitant un passage pour ledit conducteur, lequel bobinage s'étend de manière homogène sur l'essentiel de la circonférence de l'anneau à l'exception d'un troncon (20) où le bobinage présente une discontinuité structurelle, le capteur comportant au moins un bobinage complémentaire (12) sensiblement identique, lesquels bobinages (10, 12) sont disposés coaxialement **caractérisé en ce que** les bobinages (10, 12) sont orientés de sorte que les discontinuités structurelles des bobinages (10, 12) soient angulairement régulièrement réparties autour de l'axe commun des bobinages suivant la circonférence dudit passage et **en ce que** lesdits bobinages (10, 12) sont reliés en série.

2. Capteur selon la revendication 1, **caractérisé en ce qu'**il comporte deux bobinages (10, 12) disposés symétriquement par rapport à leur axe commun.

3. Capteur selon la revendication 1 ou 2, **caractérisé en ce que** chaque bobinage est enroulé sur un noyau amagnétique (18) conformé en anneau.

4. Capteur selon l'une quelconque des revendications précédentes, **caractérisé en ce que** chaque bobinage (10, 12) comporte un nombre paire de couches de spires jointives superposées suivant la circonférence de l'anneau, les spires des couches d'une même paire de couches étant bobinées dans des sens opposés.

5. Capteur selon l'une quelconque des revendications précédentes, **caractérisé en ce que** les bobinages sont reçus dans un boîtier de protection (14).

6. Capteur selon la revendication 5, **caractérisé en ce que** ledit boîtier de protection (14) délimite une chambre annulaire (36) de réception des bobinages (10, 12), lesquels bobinages y sont enrobés dans une résine.

7. Capteur selon l'une quelconque des revendications précédentes, **caractérisé en ce que** chaque bobinage (10, 12) présente, suivant sa périphérie, deux tronçons rectilignes parallèles (24, 25) reliés l'un à l'autre par deux tronçons semi-circulaires (26, 27).

## Patentansprüche

1. Induktiver Sensor zur Messung eines Stroms in einem Leiter mit einer Spule (10), die allgemein die Form eines Ringes aufweist, der die Bahn des Leiters begrenzt, welche Spule sich in homogener Weise über den wesentlichen Teil des Umfangs des Ringes mit Ausnahme eines Teilabschnitts (20) erstreckt, in dem die Spule eine strukturelle Diskontinuität aufweist, welcher Sensor wenigstens eine komplementäre, im wesentlichen identische Spule (12) umfaßt, welche Spulen (10,12) koaxial zueinander angeordnet sind, **dadurch gekennzeichnet, dass** die Spulen (10,12) derart orientiert sind, dass die strukturelle Diskontinuität der Spulen (10,12) gleichmäßig im Winkel um die gemeinsame Achse der Spulen auf dem Umfang der Bahn verteilt sind, und dass die Spulen (10,12) in Serie geschaltet sind.

2. Sensor nach Anspruch 1, **dadurch gekennzeichnet, dass** er zwei Spulen (10,12) umfaßt, die symmetrisch in Bezug auf ihre gemeinsame Achse angeordnet sind.

3. Sensor nach Anspruch 1 oder 2, **dadurch gekennzeichnet, dass** jede Spule auf einen unmagnetischen Kern (18) gewickelt ist, der ringförmig ausgebildet ist.

4. Sensor nach einem der vorgehenden Ansprüche, **dadurch gekennzeichnet. dass** jede Spule (10,12) eine Anzahl von Paaren von Lagen von verbundenen Windungen aufweist, die entlang dem Umfang des Ringes einander überlagert sind, welche Windungen der Lagen ein- und derselben Lage in entgegengesetztem Sinne aufgewickelt sind.

5. Sensor nach einem der vorgehenden Ansprüche, **dadurch gekennzeichnet, dass** die Spulen in einem Schutzgehäuse untergebracht sind.

6. Sensor nach Anspruch 5, **dadurch gekennzeichnet, dass** das Schutzgehäuse (14) eine ringförmige Kammer (36) zur Aufnahme der Spulen (10,12) begrenzt, in denen die Spulen in einen Harz eingebettet sind.

7. Sensor nach einem der vorhergehenden Ansprüche, **dadurch gekennzeichnet, dass** jede Spule (10,12) auf ihrem Umfang zwei gradlinige, parallele Teilabschnitte (24,25) aufweist, die miteinander durch zwei halbkreisförmige Teilabschnitte (26,27) verbunden sind.

## Claims

1. Inductive sensor for measuring a current in a conductor, comprising a coil (10) having the general form of a loop defining a passage for the said conductor, this coil extending in uniform fashion along most of the circumference of the loop with the exception of one section (20) where the coil has a break in its structure, the sensor comprising at least one supplementary coil (12) which is substantially identical, and the said coils (10, 12) being arranged co-axially, **characterised in that** the coils (10, 12) are oriented in such a way that the breaks in the coils (10, 12) are regularly, angularly divided around their common axis, along the circumference of the said passage, and **in that** the said coils (10, 12) are connected in series.

2. Sensor according to claim 1, **characterised in that** it comprises two coils (10, 12) arranged symmetrically, relative to their common axis.

3. Sensor according to claim 1 or 2, **characterised in that** each coil is wound around a non-magnetic core (18) formed in a loop.

4. Sensor according to any of the preceding claims, **characterised in that** each coil (10, 12) comprises an even number of superimposed layers of closely wound coils following the circumference of the loop, the coils of the layers of one pair of layers being wound in opposite directions.

5. Sensor according to any of the preceding claims, **characterised in that** the coils are received in a protective casing (14).

6. Sensor according to claim 5, **characterised in that** the said protective casing (14) defines an annular chamber (36) for receiving the coils (10, 12) in which the said coils are coated in a resin.

7. Sensor according to any of the preceding claims, **characterised in that** each coil (10, 12) has, around its periphery, two parallel rectilinear sections (24, 25) connected to each other by two semi-circular sections (26, 27).
